# FASCICULE DE BREVET EUROPEEN

(11) **EP 3 853 910 B1**
(45) Date de publication et mention de la délivrance du brevet: **04.06.2025**
(21) Numéro de dépôt: 19769512.5
(22) Date de dépôt: 19.09.2019
(51) Int. Cl.: H10F 19/80, H10F 19/85

(54) **LAMINÂT FLEXIBLE DE CELLULES PHOTOVOLTAÏQUES ET PROCÉDÉ DE FABRICATION ASSOCIÉ**
FLEXIBLES LAMINAT AUS FOTOVOLTAISCHEN ZELLEN UND ZUGEHÖRIGES HERSTELLUNGSVERFAHREN
FLEXIBLE LAMINATE OF PHOTOVOLTAIC CELLS AND ASSOCIATED PRODUCTION METHOD

(30) Priorité: 22.09.2018 FR 1858617
(43) Date de publication de la demande: 28.07.2021
(73) Titulaire: TOTAL SE, 92400 Courbevoie (FR)
(72) Inventeur: CASSAGNE, Valérick, 91470 Limours (FR); LEROY, Frédéric, 94300 Vincennes (FR); SANDER, Martin, 91120 Palaiseau (FR)
(74) Mandataire: Innovincia
(86) Numéro de dépôt international: PCT/EP2019/075260
(87) Numéro de publication internationale: WO 2020/058454

(56) Documents cités:
- EP-A2- 1 458 035
- WO-A1-2004/055908
- US-A1- 2011 036 390
- US-A1- 2014 144 487
- US-B2- 9 151 517

## Description

La présente invention concerne le domaine des modules photovoltaïques. Plus particulièrement, la présente invention concerne des modules photovoltaïques laminés. Par ailleurs, la présente invention se rapporte également à un procédé de fabrication d'un tel laminât flexible constituant le module photovoltaïque.

Du fait de la réduction du stock des énergies fossiles et de l'augmentation de la pollution générée par la consommation de ces énergies fossiles, on se tourne de plus en plus vers des ressources d'énergies renouvelables et la consommation d'énergie dans une logique de développement durable. Cette tendance conduit naturellement à privilégier les énergies renouvelables telles que l'énergie solaire. Il est désormais classique d'installer des panneaux photovoltaïques notamment sur les toitures des entreprises, des bâtiments publics, ou simplement sur les toits des habitations particulières pour fournir de l'énergie aux équipements de l'habitation en question.

La composition des modules photovoltaïques doit être suffisamment fine pour limiter leurs poids et leurs encombrements, ce qui permet par exemple de les embarquer sur un véhicule, d'être intégrés à la structure d'un véhicule, ou d'être intégrés à des structures légères de bâtiments. De façon à s'adapter à des endroits très divers et de fonctionner tout en étant soumis à des agressions climatiques, des vibrations et des contraintes mécaniques en général sur de longues périodes, parfois plus de vingt ans. Les modules doivent posséder ainsi une structure suffisamment résistante tout en étant légère. Pour résoudre ces contraintes, il est connu d'encapsuler des cellules photovoltaïques dans des couches d'encapsulation comportant une résine polymérisable afin d'assurer la liaison entre les différentes couches composant le module photovoltaïque sans l'habituelle plaque de verre pour les modules standards qui alourdit le module photovoltaïque. Comme cela, les cellules photovoltaïques sont protégées tant d'un point de vue mécanique que des conditions extérieures, de l'air, de l'eau et des rayonnements ultra-violets.

En outre, la forme du support peut varier de façon sensible, et notamment présenter une surface de réception incurvée. Il est donc nécessaire de pouvoir adapter la forme du module photovoltaïque à celle du support. De façon générale, lors de la conception et de la fabrication d'un module photovoltaïque encapsulé, également appelé laminé, on cherche à assurer au module photovoltaïque l'ensemble des propriétés suivantes :
- épaisseur minimale,
- légèreté,
- déformabilité,
- flexibilité,
- translucidité,
- étanchéité,
- fiabilité,
- robustesse.

Toutefois, il a été constaté que les résines de type éthylène-acétate de vinyle (EVA) ou de type époxy, utilisées pour encapsuler les cellules photovoltaïques du laminât, ont tendance à jaunir du fait de leur exposition aux rayonnements ultra-violet, ce qui diminue les rendements de conversion dans le temps du laminât, notamment lorsque ces résines forment une couche avant d'encapsulation, c'est-à-dire la couche du laminât destinée à être traversée en premier par les rayons lumineux du soleil.

On connaît des documents US 2013/0133726, US 9312425, US 9035172, et WO 2014/081999, l'utilisation d'une résine d'encapsulation de type polyoléfine. Ces documents précisent que les polyoléfines ne jaunissent pas au fur et à mesure de leur exposition aux rayonnements ultraviolets, ce qui permet notamment de prévenir les pertes de rendements de conversion des modules photovoltaïques. Cependant, les différents modules photovoltaïques décrits dans ces documents présentent une résistance aux chocs ou aux déformations assez limitée pouvant être préjudiciable à l'intégrité des cellules et de ces modules photovoltaïques dans le temps. On connaît des documents EP 1 458 035 A2, WO 2004/055908 A1, US 2011/036390 A1, et US 9 151 517 B2 l'utilisation de tissue de fibre de verre dans un laminât photovoltaïque.

La présente invention a pour objectif de pallier au moins partiellement aux inconvénients de l'art antérieur exposés ci-dessus, en proposant un laminât flexible dont les rendements de conversion et l'intégrité ne s'altèrent pas dans le temps.

Un autre objectif de la présente invention est de proposer un procédé de fabrication d'un tel laminât flexible.

Afin d'atteindre au moins partiellement au moins un des objectifs précités, la présente invention a pour objet un laminât flexible de cellules photovoltaïques comprenant au moins :
- une couche de cellules photovoltaïques connectées entre elles, et
- une couche frontale et une couche arrière d'encapsulation de la couche de cellules photovoltaïques, lesdites couches frontale et arrière d'encapsulation prenant la couche de cellules photovoltaïques en sandwich,
la couche frontale d'encapsulation comprenant au moins un tissu de fibres de verre et au moins une première résine d'encapsulation comprenant au moins une polyoléfine, et en ce que la couche arrière d'encapsulation comprend au moins un tissu de fibres de verre et une deuxième résine d'encapsulation.

L'utilisation d'une résine d'encapsulation à base de polyoléfine, au moins pour la couche frontale d'encapsulation permet de prévenir le jaunissement de cette dernière et donc la diminution des rendements de conversion de ce module photovoltaïque. Par ailleurs, la combinaison de la résine d'encapsulation avec un tissu de fibres de verre pour la couche frontale et pour la couche arrière d'encapsulation permet de conférer au laminât une résistance aux chocs et donc de garantir l'intégrité de ce dernier dans le temps.

Le laminât flexible selon la présente invention peut présenter en outre une ou plusieurs des caractéristiques suivantes prises seules ou en combinaison.

L'au moins une polyoléfine comprise dans la première résine d'encapsulation peut être choisie parmi les polyoléfines linéaires ou les polyoléfines ramifiées.

Selon un mode de réalisation particulier, la polyoléfine peut être choisie parmi le polyéthylène, le polyéthylène ramifié, le polyéthylène linéaire basse densité, le polyéthylène linéaire haute densité, le polypropylène.

La polyoléfine peut notamment être choisie parmi les copolymères d'éthylène-octène ou encore d'éthylène-butène.

La première résine d'encapsulation peut présenter une viscosité complexe inférieure à 10000 Pa.s à 90°C.

L'au moins une polyoléfine de la première résine d'encapsulation peut présenter un pourcentage massique en oxygène et en azote inférieur à 5 % dans sa chaîne principale ou dans sa chaîne linéaire.

La première résine d'encapsulation peut présenter une résistivité volumique d'au moins 10¹⁵Ω.cm.

La polyoléfine de la première couche peut comprendre un antioxydant tel qu'une amine encombrée stabilisatrice de lumière (HALS).

La polyoléfine peut présenter une densité comprise entre 0,83 et 0,93.

De manière alternative ou en complément, la polyoléfine peut présenter une dureté en échelle de mesure Shore A comprise entre 48 et 100.

De manière optionnelle, la polyoléfine peut présenter une dureté en échelle de mesure Shore D comprise entre 10 et 50.

De manière alternative ou en complément, la polyoléfine peut présenter une résistance en traction comprise entre 2 MPa et 30 MPa.

De manière optionnelle, la polyoléfine peu présenter un allongement en traction supérieur à 300 %, et notamment compris entre 600 % et 850 %.

La deuxième résine d'encapsulation peut être choisie parmi les résines éthylène-acétate de vinyle (EVA), les résines époxy, les résines polyoléfines.

La deuxième résine d'encapsulation peut présenter une viscosité complexe inférieure à 10000 Pa.s à 90°C.

La première et la deuxième résines d'encapsulation peuvent avoir la même composition chimique.

Le tissu de fibres de verre de la couche arrière ou de la couche frontale d'encapsulation présente une densité de fibres comprise entre 100 g/m² et 300 g/m².

Les tissus de fibres de verre des couches frontale et arrière d'encapsulation sont pré-imprégnés respectivement avec la première et la deuxième résines d'encapsulation.

Les fibres de verre composant les tissus de fibres de verre présentent un diamètre compris entre 0,01 mm et 0,1 mm.

Les fibres de verre peuvent comporter des fonctions silanol.

La couche frontale d'encapsulation peut présenter une transmittance supérieure ou égale à 80 %, de préférence supérieure à 90 %, pour les longueurs d'ondes comprises entre 315 nm et 1200 nm.

Le laminât flexible peut comporter une feuille arrière disposée au contact de la couche arrière d'encapsulation, ladite feuille arrière comprenant une ou plusieurs couches.

Au moins une couche de la feuille arrière peut comprendre un polymère hydrophobe.

Le polymère hydrophobe peut être un polymère fluoré choisi parmi les polyfluorures de vinylidène (PVDF), les polyfluorures de vinyle (PVF), les polytétrafluoroéthylènes (PTFE), les éthylène tétrafluoroéthylènes (ETFE).

Le polymère hydrophobe peut être choisi parmi les polypropylènes (PP), les sulfures de polyphénylènes (PPS), les polyesters, les polycarbonates, les oxydes de polyphénylènes (PPO), les polyéthylène téréphtalates (PET), les polyuréthanes, les acryliques, ou les silicones.

Le laminât flexible peut présenter une couche avant transparente disposée au contact de la couche frontale d'encapsulation, ladite couche avant étant configurée pour conférer au laminât des propriétés anti-encrassement et/ou des propriétés anti-réfléchissantes et/ou des propriétés hydrophobes.

La couche avant peut être formée par un film ou un vernis.

Le film de la couche avant peut être constitué d'un matériau choisi parmi les polyfluorures de vinylidène (PVDF), les polyfluorures de vinyle (PVF), les éthylènes tétrafluoroéthylènes (ETFE), les polyéthylènes téréphtalates (PET), les polyuréthanes, les acryliques, les silicones, les polycarbonates (PC), ou encore les polyméthacrylates de méthyle (PMMA).

Le vernis de la couche avant peut être un vernis à base polymérique de type polyuréthane, acrylique, polyester, ou encore silicone.

La présente invention a également pour objet un procédé de fabrication d'un laminât flexible tel que défini précédemment, le procédé comprenant les étapes suivantes :
- préparation d'un empilement de couches comprenant au moins :
   ∘ une couche frontale d'encapsulation, comprenant au moins un tissu de fibres de verre et au moins une première résine d'encapsulation comprenant au moins une polyoléfine,
   ∘ une couche des cellules photovoltaïques, et
   ∘ une couche arrière d'encapsulation, comprenant une deuxième résine d'encapsulation et un tissu de fibres de verre,
- introduction de l'empilement de couches dans une chambre de lamination d'un four de lamination,
- tirage sous vide, afin d'aspirer l'air à l'intérieur de la chambre de lamination et entre les différentes couches de l'empilement,
- compression de l'empilement de couches afin de former le laminât,
- chauffage de la chambre de lamination à une température prédéterminée afin de permettre un déclenchement d'une réaction de polymérisation de la première et de la deuxième résines d'encapsulation,
- ventilation de la chambre de lamination, et
- extraction du laminât de la chambre de lamination.

Le procédé de fabrication peut comprendre en outre une ou plusieurs des caractéristiques suivantes prises seules ou en combinaison.

Selon l'invention, le tissu de fibres de verre de la couche arrière d'encapsulation est imprégné avec la deuxième résine d'encapsulation lors d'une étape de pré-imprégnation préalable à l'étape de préparation de l'empilement de couches.

Selon un aspect, la feuille arrière peut être laminée avec l'empilement de couches lors de l'étape de compression de l'empilement de couches.

Selon cet aspect, l'empilement de couches comprend en outre la feuille arrière disposée au contact de la couche arrière d'encapsulation de manière à ce que la couche arrière d'encapsulation est prise en sandwich entre la feuille arrière et la couche de cellules photovoltaïques.

Selon un autre aspect, la feuille arrière peut être disposée sur la couche arrière d'encapsulation après l'étape d'extraction du laminât flexible de la chambre de lamination.

Selon une variante, la couche avant peut être disposée sur la couche frontale d'encapsulation après l'étape d'extraction du laminât flexible de la chambre de lamination.

La couche avant et/ou la feuille arrière peut être disposée sur la couche frontale d'encapsulation, respectivement sur la couche arrière d'encapsulation, après l'étape d'extraction du laminât flexible de la chambre de lamination par une des techniques suivantes : trempage, impression, dépôt physique en phase vapeur, dépôt chimique en phase vapeur, revêtement, ou encore collage.

Selon une autre variante, la couche avant peut être laminée avec l'empilement de couches lors de l'étape de compression de l'empilement de couches.

Selon cette autre variante, l'empilement de couches comprend en outre la couche avant disposée au contact de la couche frontale d'encapsulation de manière à ce que la couche frontale d'encapsulation est prise en sandwich entre la couche avant et la couche de cellules photovoltaïques.

D'autres caractéristiques et avantages de la présente invention apparaîtront plus clairement à la lecture de la description suivante, fournie à titre illustratif et non limitatif et des dessins annexés dans lesquels :
- la figure 1 est une représentation schématique de dessus d'un laminât flexible,
- la figure 2 est une représentation schématique en coupe transversale du laminât flexible de la figure 1 selon un mode de réalisation particulier,
- la figure 3 est une représentation schématique en coupe transversale du laminât flexible de la figure 1 selon une variante,
- la figure 4 est une représentation schématique en coupe transversale du laminât flexible de la figure 1 selon une autre variante,
- la figure 5 est une représentation schématique en coupe transversale du laminât flexible de la figure 1 selon encore une autre variante, et
- la figure 6 est une représentation schématique d'un organigramme illustrant différentes étapes d'un procédé de fabrication du laminât flexible de la figure 1.

Les éléments identiques sur les différentes figures portent les mêmes références numériques.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent uniquement à un seul mode de réalisation. De simples caractéristiques de différents modes de réalisation peuvent également être combinées et/ou interchangées pour fournir d'autres réalisations.

Dans la description suivante, on peut indexer certains éléments ou paramètres, comme par exemple premier élément ou deuxième élément ainsi que premier paramètre et deuxième paramètre, ou encore premier critère et deuxième critère, etc. Dans ce cas, il s'agit d'un simple indexage pour différencier et dénommer des éléments proches mais non identiques et on peut aisément interchanger de telles dénominations sans sortir du cadre de la présente description. Cette indexation n'implique pas non plus un ordre dans le temps pour apprécier tel ou tel critère.

Dans la description suivante, on entend par « couche frontale », la surface du laminât exposée en premier aux rayons solaires à l'état installé du laminât. De même, on entend par « couche arrière » dans la description suivante, la couche opposée à la couche frontale, c'est-à-dire la surface qui est impactée en dernier par les rayons solaires lors de leur passage à travers le laminât flexible à l'état installé du laminât.

Ensuite, on entend par « polyoléfine » dans la description suivante, un polymère aliphatique saturé, synthétique issu de la polymérisation d'une oléfine, comme l'éthylène ou ses dérivés par exemple, une telle polyoléfine peut également être dénommée polyalcène.

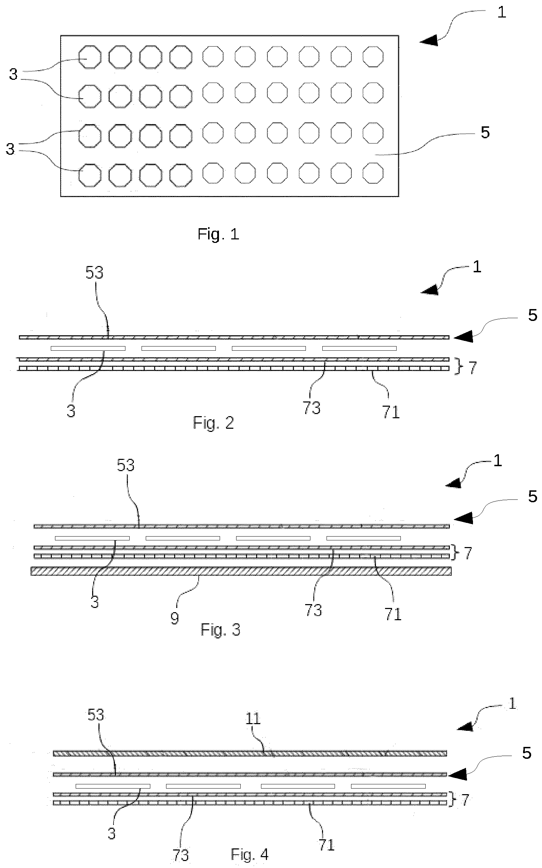

D'autre part, en référence aux figures 2 à 4, les différentes couches composant un laminât 1 sont espacées les une des autres. Cette représentation est uniquement réalisée pour mieux identifier les différentes couches. A l'état livré du laminât flexible 1, les différentes couches représentées sont en contact les unes avec les autres.

En référence aux figures 1 à 5, il est représenté un laminât flexible 1 de cellules photovoltaïques. Le laminât flexible 1 comprend au moins une couche de cellules photovoltaïques 3 connectées entre elles et une couche frontale 5 et une couche arrière 7 d'encapsulation de la couche de cellules photovoltaïques 3. Les couches frontale 5 et arrière 7 d'encapsulation prennent la couche de cellules photovoltaïques 3 en sandwich.

La couche de cellules photovoltaïques 3 peut être composée de cellules photovoltaïques en silicium, comme par exemple en silicium monocristallin, multicristallin, ou encore en couches minces. De manière alternative, d'autres types de cellules photovoltaïques peuvent également être utilisées pour former cette couche de cellules photovoltaïques 3, comme par exemple des cellules photovoltaïques organiques.

La couche frontale d'encapsulation 5 comprend au moins un tissu de fibres de verre 51 et au moins une première résine d'encapsulation 53. Afin que le laminât 1 présente de bon rendements de conversion, le couche frontale d'encapsulation 5 présente une transmittance supérieure ou égale à 80 %, de préférence supérieure à 90 %, pour les longueurs d'ondes comprises entre 315 nm et 1200 nm. En effet, il est nécessaire que cette couche frontale d'encapsulation 5 présente une transmittance élevée pour certaines longueurs d'onde du spectre solaire, et en particulier la partie utile du spectre solaire pour la conversion photovoltaïque, pour ne pas nuire aux rendements de conversion du laminât flexible 1.

La première résine d'encapsulation 53 comprend au moins une polyoléfine. L'utilisation d'une polyoléfine dans la couche frontale d'encapsulation 5 permet de prévenir la jaunissement de cette dernière et donc la baisse des rendements de conversion du laminât flexible 1. De plus, les polyoléfines sont hydrophobes et présentent une grande inertie chimique aux solvants, aux acides et aux bases, ce qui permet une bonne protection de la couche de cellules photovoltaïques 3 encapsulée et contribue à l'intégrité du laminât flexible 1 dans le temps.

Plus particulièrement, la polyoléfine peut être choisie parmi les polyoléfines linéaires ou les polyoléfines ramifiées. Selon les différents modes de réalisation représentés en référence aux figures 1 à 5, la polyoléfine peut être choisie parmi le polyéthylène, le polyéthylène ramifié, le polyéthylène linéaire basse densité, le polyéthylène linéaire haute densité, le polypropylène. La polyoléfine peut notamment être choisie parmi les copolymères d'éthylène-octène ou encore d'éthylène-butène.

De manière optionnelle, la polyoléfine de la première résine d'encapsulation 53 peut comprendre un antioxydant tels qu'une amine encombrée stabilisatrice de lumière (HALS). La présence d'un antioxydant permet de prévenir l'oxydation de la polyoléfine et permettre à cette dernière de conserver ses différentes propriétés physiques, et notamment de flexibilité et de résistance à la traction.

Selon le mode de réalisation particulier de la figure 1, la polyoléfine de la première résine d'encapsulation 53 présente une densité comprise entre 0,83 et 0,93. Une telle densité pour la polyoléfine permet de limiter la masse de la couche frontale d'encapsulation 5, ce qui permet notamment de limiter la masse du laminât flexible 1. D'autre part, cette polyoléfine présente une dureté en échelle de mesure Shore A comprise entre 48 et 100 et une dureté en échelle de mesure Shore D comprise entre 10 et 50. Selon la définition des normes ISO 868 et 7619 l'échelle de mesure Shore A est utilisée pour les matériaux mous et l'échelle de mesure Shore D est utilisée pour les matériaux durs. De telles duretés pour la polyoléfine permettent de protéger les cellules photovoltaïques 3 des chocs ou des impacts que ces dernières peuvent être amenées à subir une fois ce laminât flexible 1 installé ou encore lors du transport ou du stockage de ce dernier. Par ailleurs, la polyoléfine composant la première résine d'encapsulation 53 présente une résistance en traction comprise entre 2 et 30 MPa et un allongement en traction supérieur à 300 %, et notamment compris entre 600 % et 850 %. De telles propriétés de traction permettent à la couche frontale d'encapsulation 5 d'être déformable et de conférer des propriétés de flexibilité au laminât 1, comme cela est développé plus en détail ultérieurement.

D'autre part, la couche frontale d'encapsulation 5 comprend au moins un tissu de fibres de verre 51 et une première résine d'encapsulation 53. De la même manière, la couche arrière d'encapsulation 7 comprend au moins un tissu de fibres de verre 71 et une deuxième résine d'encapsulation 73.

La deuxième résine d'encapsulation 73 peut être choisie parmi les résines éthylène-acétate de vinyle (EVA), les résines époxy, les résines polyesters, les résines polyuréthane, les résines acrylique, ou encore les résines polyoléfines. L'utilisation de résines EVA ou époxy pour la deuxième résine d'encapsulation 73 n'est pas problématique car cette couche arrière d'encapsulation 7 peut être traversée par les rayons lumineux après la couche de cellules photovoltaïques 3. Selon un mode de réalisation particulier, la première 53 et la deuxième 73 résines d'encapsulation peuvent avoir la même composition chimique. Cela permet notamment de s'affranchir de problèmes de compatibilité chimique entre ces première 53 et deuxième 73 résines d'encapsulation qui pourrait nuire à leur adhérence et donc à l'encapsulation de la couche de cellules photovoltaïques 3 du laminât flexible 1 et de simplifier la logistique industrielle.

Par ailleurs, la première 53 et la deuxième 73 résines d'encapsulation peuvent présenter une viscosité complexe inférieure à 10000 Pa.s à 90°C. La valeur de la viscosité complexe est un critère important pour la performance et la fiabilité du laminât flexible 1. En effet, si cette dernière est trop importante, la première 53 et la deuxième 73 résine d'encapsulation ne pourra pas facilement diffuser dans les fibres du tissu de fibres de verre 51, 71 ou encore entre les cellules photovoltaïques et donc assurer la transparence de de la couche arrière d'encapsulation 7, ou encore le contact avec les cellules photovoltaïques 3, ce qui pourrait être préjudiciable à l'intégrité du laminât flexible 1.

De plus, et également afin d'éviter les risques de fissures de la première résine d'encapsulation 53, et de la deuxième résine d'encapsulation 73 lorsque celle-ci est composée d'une polyoléfine, la polyoléfine présente un pourcentage massique en oxygène et en azote inférieur à 5 % dans sa chaîne principale ou dans sa chaîne linéaire, c'est-à-dire que le pourcentage massique combiné d'oxygène et d'azote dans la polyoléfine est inférieur à 5 %. De plus, lorsque la deuxième résine d'encapsulation 73 est une polyoléfine, cette dernière peut présenter les mêmes caractéristiques physiques que celle de la première résine d'encapsulation 53 énoncées précédemment.

D'autre part, les première 53 et deuxième 73 résines d'encapsulation présentent une résistivité volumique d'au moins 10¹⁵ Ω.cm. Ces première 53 et deuxième 73 résines d'encapsulation correspondent donc à des isolants. En effet, pour prévenir les court-circuits entre les différentes cellules photovoltaïques de la couche de cellules photovoltaïques 3, il est nécessaire que les première 53 et deuxième 73 résines d'encapsulation soient des isolant car elles sont en contact avec les cellules photovoltaïques 3 du laminât flexible 1.

Par ailleurs, le tissu de fibres de verre 71 de la couche arrière d'encapsulation 7 présente une densité de fibres comprise entre 100 g/m² et 300 g/m². La densité du tissu de fibres de verre permet à la deuxième résine d'encapsulation 73 de diffuser à travers ce tissu de fibres de verre 71 au cours du procédé de fabrication de ce laminât flexible 1 et également de protéger la couche de cellules photovoltaïques 3 d'éventuels chocs, impacts, ou encore déformations qu'elle pourrait subir au cours du transport du laminât flexible 1, de son installation ou encore au cours de son fonctionnement comme ce laminât 1 est destiné à être installé en extérieur. Ainsi, ce tissu de fibres de verre 71 permet d'assurer l'intégrité physique du laminât flexible 1 dans le temps.

Ce tissu de fibres de verre 71 peut par exemple être réalisé en verre de type E, en verre de type ECR, ou encore en verre de type AR. Ces différents verres présentent une bonne résistance à la chaleur et aux attaques chimiques, une bonne stabilité thermique et des propriétés de résistance en tension et en compression satisfaisantes pour permettre leur utilisation comme composant du laminât flexible 1.

D'autre part, les fibres de verre composant le tissu de fibres de verre 71 peuvent présenter une diamètre compris entre 0,01 mm et 0,1 mm.

Par ailleurs, les fibres de verre composant le tissu de fibres de verre 71 peuvent présenter des fonctions silanol, et notamment lorsque la deuxième résine d'encapsulation 73 est une polyoléfine. En effet, les groupements silanol présentent une bonne affinité chimique avec les polyoléfines, ce qui permet entre autre de renforcer la cohésion de la deuxième résine d'encapsulation 73 avec le tissu de fibres de verre 71 et donc avec les cellules photovoltaïques 3.
Selon un mode de réalisation particulier, les tissus de fibres de verre 51, 71 sont pré-imprégnés respectivement avec la première 53 et la deuxième 73 résines d'encapsulation. Ceci permet de diminuer la durée de la réalisation d'un tel laminât flexible 1 et plus précisément de diminuer la durée du procédé de fabrication 100 présenté plus en détails par la suite.

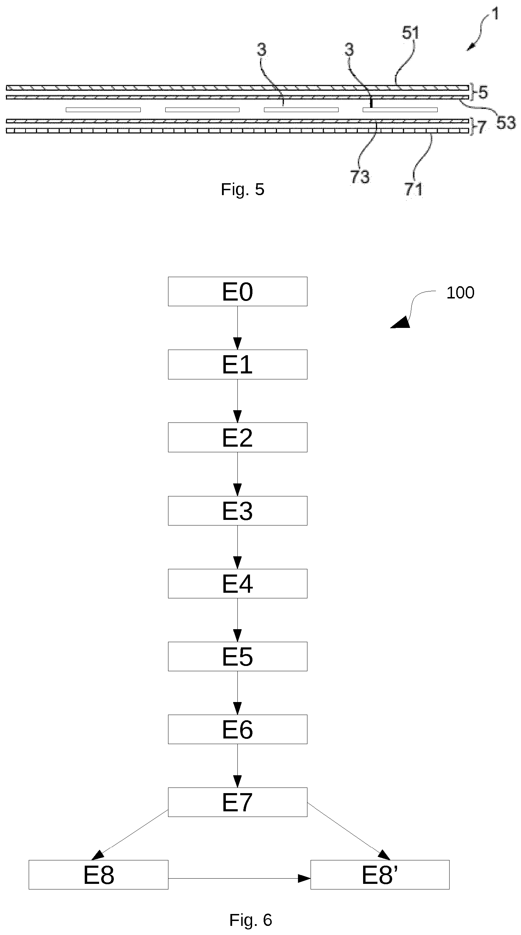

Comme illustré en figure 5, la couche frontale d'encapsulation 5 du laminât flexible 1 comporte au moins un tissu de fibres de verre 51. Ce tissu de fibres de verre 51 peut présenter les mêmes propriétés physico-chimiques que le tissu de fibres de verre 71 de la couche arrière d'encapsulation 7 décrites précédemment. Par ailleurs, la présence de ce tissu de fibres de verre 51 contribue également à améliorer la résistance de ce laminât flexible 1 aux impacts que celui-ci peut être amené à subir lorsqu'il est installé par exemple sur le toit d'un bâtiment.

En référence aux figures 2 à 4, les couches frontale 5 et arrière 7 d'encapsulation présentent une épaisseur pouvant être comprise entre 0,05 mm et 3 mm. Une telle épaisseur des couches frontale 5 et arrière 7 d'encapsulation permet l'obtention d'un laminât flexible 1 de faible épaisseur, ce qui permet notamment de limiter les coûts liés à son stockage ou encore à son transport. Par ailleurs, les différents éléments constitutifs de ce laminât flexible 1 présentent des masses légères, ce qui permet d'obtenir un laminât flexible 1 de masse faible, typiquement inférieure ou égale à 5 kg/m². Par exemple, pour un laminât présentant une longueur de 1200 mm et une largeur de 526 mm, un tel laminât flexible 1 présente une masse de 3,16 kg ce qui représente une masse par unité de surface de 5,00 kg/m², ou encore pour un laminât présentant une longueur de 2030 mm et une largeur de 800 mm un tel laminât flexible 1 présente une masse de 6,9 kg ce qui représente une masse par unité de surface de 4,24 kg/m². De plus, un tel laminât 1 présente des propriétés de flexibilité qui permettent également de faciliter son transport ainsi que son installation. On entend ici par flexible un élément qui, lors de l'application d'un certain rayon de courbure, ne perd pas son intégrité physique ou ses performances électriques. Plus particulièrement, un élément flexible ici est un élément qui ne se fissure pas lorsqu'on lui applique un certain rayon de courbure, et plus particulièrement au sens de la présente description l'élément doit supporter sans dommage un rayon de courbure de 100 cm.

Selon le mode de réalisation particulier des figures 1, 2 et 5, le laminât flexible 1 présente uniquement la couche frontale 5 et la couche arrière 7 d'encapsulation et la couche de cellules photovoltaïques 3.

Selon une variante représentée en référence à la figure 3, le laminât flexible 1 peut comporter une feuille arrière 9 disposée au contact de la couche arrière d'encapsulation 7. La feuille arrière 9 peut comprendre une ou plusieurs couches. Cette feuille arrière peut conférer au laminât flexible 1 des propriétés additionnelles ou renforcer certaines des propriétés des première 53 et deuxième 73 résines d'encapsulation. Par exemple, au moins une couche de la feuille arrière 9 comprend un polymère hydrophobe afin d'améliorer la résistance à l'humidité du laminât flexible 1. Ce polymère hydrophobe peut être un polymère fluoré choisi parmi les polyfluorures de vinylidène (PVDF), les polyfluorures de vinyle (PVF), les polytétrafluoroéthylènes (PTFE), les éthylène tétrafluoroéthylènes (ETFE), ou encore être choisi parmi les polypropylènes (PP), les sulfures de polyphénylènes (PPS), les polyesters, les polycarbonates, les oxydes de polyphénylènes (PPO), les polyéthylène téréphtalates (PET), les polyuréthanes, les acryliques, ou les silicones.

Selon une autre variante, représentée en référence à la figure 4, le laminât flexible 1 peut présenter une couche avant 11 transparente disposée au contact de la couche frontale d'encapsulation 5. On entend ici par transparente, le fait que cette couche avant 11 présente une transmittance supérieure ou égale à 80 %, de préférence supérieure ou égale à 90 %, pour les longueurs d'onde comprises entre 315 nm et 1200 nm. La couche avant 11 est configurée pour conférer au laminât flexible 1 des propriétés anti-encrassement et/ou des propriétés anti-réfléchissantes et/ou des propriétés hydrophobes par exemple. La couche avant 11 peut être formée par un film ou un vernis par exemple. Le film de la couche avant 11 peut être constitué d'un matériau choisi parmi les polyfluorures de vinylidène (PVDF), les polyfluorures de vinyle (PVF), les éthylènes tétrafluoroéthylènes (ETFE), les polyéthylènes téréphtalates (PET), les polyuréthanes, les acryliques, les silicones, les polycarbonates (PC), ou encore les polyméthacrylates de méthyle (PMMA). Par ailleurs, le vernis de la couche avant 11 peut être un vernis à base polymérique de type polyuréthane, acrylique, polyester, ou encore silicone.

Par ailleurs, selon une variante non représentée ici, le laminât flexible 1 peut présenter la feuille arrière 9 et la couche avant 11.

En référence aux différents modes de réalisation particuliers représentés en référence aux figures 2 à 4, la présence de la feuille arrière 9 ou encore de la couche avant 11 n'altèrent pas les propriétés de flexibilité du laminât flexible 1. De plus, cette feuille arrière 9 ou encore cette couche avant 11 sont de faible épaisseur, ce qui permet entre autre de conserver un laminât flexible 1 dont l'épaisseur peut rester inférieure à 5 mm et présentant également une masse inférieure ou égale à 5 kg/m² pour un laminât présentant des dimensions telles qu'énoncées précédemment.

En référence à la figure 6, il est représenté un organigramme schématisant un procédé de fabrication 100 du laminât flexible 1 décrit précédemment.

Le procédé de fabrication 100 comprend une étape de préparation E1 d'un empilement de couches comprenant au moins une couche frontale d'encapsulation 5, une couche des cellules photovoltaïques 3, et une couche arrière d'encapsulation 7 telles que décrites précédemment.

Le procédé de fabrication 100 met ensuite en œuvre une étape d'introduction E2 de l'empilement de couches dans une chambre de lamination d'un four de lamination, puis une étape de tirage sous vide E3, afin d'aspirer l'air à l'intérieur de la chambre de lamination et entre les différentes couches de l'empilement. Cette étape de tirage sous vide E3 peut par exemple être réalisée à l'aide d'une pompe à vide. A la fin de cette étape de tirage sous vide E3, la pression à l'intérieur de la chambre de lamination peut être inférieure à 20 mbar, et notamment de l'ordre de 1 mbar. L'évacuation de l'air de l'intérieur de la chambre de lamination permet notamment de prévenir la formation de bulles dans les première 53 et deuxième 73 résines d'encapsulation lors de leur réaction de polymérisation. Cette étape de tirage sous vide E3 peut faire l'objet d'un pré-chauffage afin de dégazer plus rapidement les composés volatils du laminât flexible 1. Lorsqu'un tel pré-chauffage est réalisé, la température à l'intérieur de la chambre de lamination reste inférieure à la température de polymérisation des première 53 et deuxième 73 résines d'encapsulation. Par exemple, la température à l'intérieur de la chambre de lamination lors de cette étape de pré-chauffage peut être de l'ordre de 50°C.

Une fois cette pression atteinte à l'intérieur de la chambre de lamination, le procédé de fabrication 100 met en œuvre une étape de compression E4 de l'empilement de couches afin de former le laminât flexible 1. Pour ce faire la chambre de lamination peut présenter une plaque mobile configurée pour venir comprimer l'empilement de couches.

Une fois cette pression appliquée sur l'empilement de couches, le procédé de fabrication 100 met en œuvre une étape de chauffage E5 de la chambre de lamination à une température prédéterminée afin de permettre un déclenchement d'une réaction de polymérisation de la première 53 et de la deuxième 73 résines d'encapsulation. Cette température prédéterminée correspond à la température de polymérisation de la (ou des) résine(s) d'encapsulation choisie(s). Par ailleurs, au cours de cette étape de chauffage E5, la pompe à vide est maintenue en fonctionnement de manière à aspirer les fumées et les vapeurs qui pourraient être produites au cours de la réaction de polymérisation des première 53 et deuxième 73 résines d'encapsulation.

Après une durée prédéterminée, par exemple de l'ordre de 5 minutes, la pompe à vide est stoppée et le procédé met en œuvre une étape de ventilation E6 de la chambre de lamination, puis une étape d'extraction E7 du laminât 1 obtenu de la chambre de lamination.

Selon un mode de réalisation particulier et de manière optionnelle, le tissu de fibres de verre 71 de la couche arrière d'encapsulation 7 et le tissu de fibres de verre 51 de la couche frontale d'encapsulation 5 peuvent être imprégnés respectivement avec la deuxième résine d'encapsulation 73 et la première résine d'encapsulation 53. Pour ce faire, le procédé de fabrication 100 peut comprendre une étape de pré-imprégnation E0 préalable à l'étape de préparation E1 de l'empilement de couches. En effet, il peut être possible d'avoir des tissus de fibres de verre 51, 71 déjà imprégnés avec la première 53 ou la deuxième 73 résine d'encapsulation. Ainsi, il est possible de diminuer les temps nécessaires à la réalisation ce procédé de fabrication 100.

Afin d'obtenir les laminâts flexibles 1 représentés en référence aux figures 3 et 4, la feuille arrière 9 et/ou la couche avant 11 peuvent être laminées avec l'empilement de couches lors de l'étape de compression E4 de l'empilement de couches lorsque les matériaux constitutifs de la feuille arrière 9 ou de la couche avant 11 présentent des températures de fusion pouvant être suffisantes pour résister à l'étape de chauffe E5 de l'empilement de couches, ou encore pour que ces matériaux constitutifs ne subissent pas de dégradation thermique liée à cette étape de chauffe E5.

Pour cela, l'empilement de couches peut comprendre en outre la feuille arrière 9 disposée au contact de la couche arrière d'encapsulation 7 de manière à ce que la couche arrière d'encapsulation 7 est prise en sandwich entre la feuille arrière 9 et la couche de cellules photovoltaïques 3, ou encore l'empilement de couches peut comprendre en outre la couche avant 11 disposée au contact de la couche frontale d'encapsulation 5 de manière à ce que la couche frontale d'encapsulation 5 est prise en sandwich entre la couche avant 11 et la couche de cellules photovoltaïques 3.

De manière alternative, la feuille arrière 9 peut être disposée sur la couche arrière d'encapsulation 7 lors d'une étape de dépôt de la couche arrière E8 postérieure à l'étape d'extraction E7 du laminât flexible 1 de la chambre de lamination, ou encore la couche avant 11 peut être disposée sur la couche frontale d'encapsulation 5 lors d'une étape de dépôt de la couche avant E8' postérieure à l'étape d'extraction E7 du laminât flexible 1 de la chambre de lamination.

Selon cette alternative, les étapes de dépôt de la couche arrière E8 ou de la couche avant E8' peuvent être réalisées après l'étape d'extraction E7 du laminât flexible 1 de la chambre de lamination par une des techniques suivantes : trempage, impression, dépôt physique en phase vapeur, dépôt chimique en phase vapeur, revêtement, ou encore collage.

Les modes de réalisations particuliers décrits ci-dessus sont donnés à titre illustratif et non limitatif. En effet, il est tout à fait possible pour l'homme de l'art de modifier l'épaisseur des couches frontale 5 et arrière 7 d'encapsulation sans sortir du cadre de la présente invention. Par ailleurs, l'homme de l'art pourra utiliser d'autres matériaux constitutifs de la couche avant 11, de la feuille arrière 9, de la deuxième résine d'encapsulation 73, du tissu de fibres de verre 71 sans sortir de la présente invention. De même, l'homme de l'art pourra utiliser d'autres polyoléfines pour la première résine d'encapsulation 53 que les différentes polyoléfines spécifiques décrites dans cette description sans sortir du cadre de la présente invention.

Ainsi, l'obtention d'un laminât flexible 1 dont les pertes de rendement de conversion sont prévenues et dont l'intégrité physique dans le temps est assurée est possible grâce au laminât flexible 1 comprenant au moins pour sa couche frontale d'encapsulation 5 une première résine d'encapsulation 53 comprenant une polyoléfine tel que décrit précédemment.

## Revendications

1. Laminât flexible (1) de cellules photovoltaïques comprenant au moins :
- une couche de cellules photovoltaïques (3) connectées entre elles, et
- une couche frontale (5) et une couche arrière (7) d'encapsulation de la couche de cellules photovoltaïques (3), lesdites couches frontale (5) et arrière (7) d'encapsulation prenant la couche de cellules photovoltaïques (3) en sandwich, **caractérisé en ce que** la couche frontale d'encapsulation (5) comprend au moins un tissu de fibres de verre (51) et au moins une première résine d'encapsulation (53) comprenant au moins une polyoléfine, et **en ce que** la couche arrière (7) d'encapsulation comprend au moins un tissu de fibres de verre (71) et une deuxième résine d'encapsulation (73), **caractérisé en ce que** les tissus de fibre de verre (51, 71) de couches frontale et arrière d'encapsulation (5, 7) sont pré-imprégnés respectivement par la première et la deuxième résines d'encapsulation (53, 73) et présentent une densité de fibres comprise entre 100 g/m2 et 300 g/m2.

2. Laminât flexible (1) selon la revendication précédente, **caractérisé en ce que** l'au moins une polyoléfine comprise dans la première résine d'encapsulation (53) est choisie parmi les polyoléfines linéaires ou les polyoléfines ramifiées.

3. Laminât flexible (1) selon l'une quelconque des revendications précédentes, **caractérisé en ce que** la première résine d'encapsulation (53) présente une viscosité complexe inférieure a 10000 Pa.s a 90°C.

4. Laminât flexible (1) selon l'une quelconque des revendications précédentes, **caractérisé en ce que** l'au moins une polyoléfine de la première résine d'encapsulation (53) présente un pourcentage massique en oxygène et en azote inférieur à 5 % dans sa chaine principale ou dans sa chaine linéaire.

5. Laminât flexible (1) selon l'une quelconque des revendications précédentes, **caractérisé en ce que** la première résine d'encapsulation (53) présente une résistivité volumique d'au moins 10₁₅Ω.cm.

6. Laminât flexible (1) selon l'une quelconque des revendications précédentes, **caractérisé en ce que** la première résine d'encapsulation (53) présente une transmittance supérieure ou égale a 80 %, de préférence supérieure a 90 %, pour les longueurs d'ondes comprises entre 315 nm et 1200 nm.

7. Laminât flexible (1) selon l'une quelconque des revendications précédentes, **caractérisé en ce que** la deuxième résine d'encapsulation (73) est choisie parmi les résines ethylene-acetate de vinyle (EVA), les résines epoxy, les résines polyolefines.

8. Procédé de fabrication (100) d'un laminât flexible (1) selon l'une quelconque des revendications précédentes, **caractérisé en ce qu'**il comprend les étapes suivantes :
- une pré-imprégnation (E0) dans laquelle le tissu de fibres de verre (51) de la couche frontale d'encapsulation (5) est imprégné avec une première résine d'encapsulation (53) et le tissu de fibres de verre (71) de la couche arrière d'encapsulation (7) est imprégné avec une deuxième résine d'encapsulation (73),
- préparation (E1) d'un empilement de couches comprenant au moins :
∘∘ une couche frontale (5) d'encapsulation, comprenant au moins un tissu de fibres
de verre (51)et au moins une première résine d'encapsulation (53) comprenant au moins une polyoléfine,
∘ une couche des cellules photovoltaïques (3), et
∘ une couche arrière (7) d'encapsulation, comprenant une deuxième résine d'encapsulation (73) et un tissu de fibres de verre (71),
- introduction (E2) de l'empilement de couches dans une chambre de lamination d'un four de lamination,
- tirage sous vide (E3), afin d'aspirer l'air a l'intérieur de la chambre de lamination et entre les différentes couches de l'empilement,
- compression (E4) de l'empilement de couches,
- chauffage (E5) de la chambre de lamination a une température prédéterminée afin de permettre un déclenchement d'une réaction de polymérisation de la première (53) et de la deuxième (73) résines d'encapsulation,
- ventilation (E6) de la chambre de lamination, et
- extraction (E7) du laminât (1) de la chambre de lamination.

## Patentansprüche

1. Biegsames Laminat (1) aus Photovoltaik-Zellen, das zumindest Folgendes umfasst:
- eine Schicht aus Photovoltaik-Zellen (3), welche miteinander verbunden sind, und
- eine vorderseitige Schicht (5) und eine rückseitige Schicht (7) zur Einkapselung der Schicht aus Photovoltaik-Zellen (3), wobei die vorderseitige (5) und die rückseitige (7) Einkapselungsschicht die Schicht aus Photovoltaikzellen (3) sandwichartig umfassen, **dadurch gekennzeichnet, dass** die vordersetige Einkapselungsschicht (5) mindestens ein Glasfasergewebe (51) sowie mindestens ein Einkapselungsharz (53) umfasst, welches mindestens ein Polyolefin umfasst, und dadurch, dass die rückseitige Einkapselungsschicht (7) mindestens ein Glasfasergewebe (71) sowie ein zweites Einkapselungskarz (73) umfasst, **dadurch gekennzeichnet, dass** die Glasfasergewebe (51, 71) der vorderseitigen und rückseitigen Einkapselungsschichten (5, 7) mit dem ersten beziehungsweise dem zweiten Einkapselungsharz (53, 73) vorimprägniert sind und eine Faserdichte im Bereich von 100 g/m2 bis 300 g/m2 aufweisen.

2. Biegsames Laminat (1) nach dem vorhergehenden Anspruch, **dadurch gekennzeichnet, dass** das mindestens eine Polyolefine, welches in dem Einkapselungsharz (53) enthalten ist, aus den unverzweigten Polyolefinen oder den verzweigten Polyolefinen ausgewählt ist.

3. Biegsames Laminat (1) nach einem beliebigen der vorhergehenden Ansprüche, **dadurch gekennzeichnet, dass** das erste Einkapselungsharz (53) eine komplexe Viskosität von weniger als 10000 Pa.s bei 90 °C aufweist.

4. Biegsames Laminat (1) nach einem beliebigen der vorhergehenden Ansprüche, **dadurch gekennzeichnet, dass** das mindestens eine Polyolefin des ersten Einkapselungsharzes (53) in seiner Hauptkette oder in seiner unverzweigten Kette einen Massenprozentanteil an Sauerstoff und an Stickstoff von weniger als 5 % aufweist.

5. Biegsames Laminat (1) nach einem beliebigen der vorhergehenden Ansprüche, **dadurch gekennzeichnet, dass** das erste Einkapselungsharz (53) einen volumenbezogenen spezifischen Widerstand von mindestens 10₁₅Ω.cm aufweist.

6. Biegsames Laminat (1) nach einem beliebigen der vorhergehenden Ansprüche, **dadurch gekennzeichnet, dass** erste Einkapselungsharz (53) für Wellenlängen im Bereich von 315 nm bis 1200 nm eine Durchlässigkeit von mindestens 80 %, vorzugweise von mehr als 90 %, aufweist.

7. Biegsames Laminat (1) nach einem beliebigen der vorhergehenden Ansprüche, **dadurch gekennzeichnet, dass** das zweite Einkapselungsharz (73) aus den EthylenVinylacetat-Harzen (EVA), den Epoxy-Harzen, den Polyolefin-Harzen ausgewählt ist.

8. Verfahren zur Herstellung (100) eines biegsamen Laminats (1) nach einem beliebigen der vorhergehenden Ansprüche, **dadurch gekennzeichnet**, das es die folgenden Schritte umfasst:
- ein Vorimprägnieren (E0), wobei das Glasfasergewebe (51) der vorderseitigen Einkapselungsschicht (5) mit einem ersten Einkapselungsharz (53) imprägniert wird und das Glasfasergewebe (71) der zweiten Einkapselungsschicht (7) mit einem zweiten Einkapselungsharz (73) imprägniert wird,
- Herstellen (E1) eines Stapels aus Schichten, der zumindest Folgendes umfasst:
∘ eine vorderseitige Einkapselungsschicht (5), die mindestens ein Glasfasergewebe (51) sowie mindestens ein erstes Einkapselungsharz (53) umfasst, welches mindestens ein Polyolefin umfasst,
∘ eine Schicht aus Photovoltaik-Zellen (3), und
∘ eine rückseitige Einkapselungsschicht (7), die ein zweites Einkapselungsharz (73) und ein Glasfasergewebe (71) umfasst,
- Einführen (E2) des Schichtenstapels in eine Laminierungskammer eines Laminierungsofens,
- Anlegen eines Vakuums (E3), um die Luft abzusaugen, welche sich im Inneren der Laminierungskammer und zwischen den verschiedenen Schichten des Stapels befindet,
- Komprimieren (E4) des Schichtenstapels,
- Aufheizen (E5) der Laminierungskammer auf eine vorbestimmte Temperatur, um das Auslösen einer Polymerisationsreaktion des ersten (53) und des zweiten (73) Einkapselungsharzes zu ermöglichen,
- Belüften (E6) der Laminierungskammer, und
- Entnehmen (E7) des Laminats (1) aus der Laminierungskammer.

## Claims

1. Flexible laminate (1) of photovoltaic cells, comprising at least:
- a layer of interconnected photovoltaic cells (3), and
- a front layer (5) and a back layer (7) for encapsulating the layer of photovoltaic cells (3), said front encapsulation layer (5) and back encapsulation layer (7) sandwiching the layer of photovoltaic cells (3), **characterized in that** the front encapsulation layer (5) comprises at least one glass-fibre fabric (51) and at least a first encapsulation resin (53) comprising at least one polyolefin, and **in that** the back encapsulation layer (7) comprises at least one glass-fibre fabric (71) and a second encapsulation resin (73), **characterized in that** the glass-fibre fabrics (51, 71) of the front and back encapsulation layers (5, 7) are pre-impregnated with the first and the second encapsulation resin (53, 73), respectively, and have a fibre density of between 100 g/m2 and 300 g/m2.

2. Flexible laminate (1) according to the preceding claim, **characterized in that** the at least one polyolefin comprised in the first encapsulation resin (53) is selected from among linear polyolefins or branched polyolefins.

3. Flexible laminate (1) according to either one of the preceding claims, **characterized in that** the first encapsulation resin (53) has a complex viscosity less than 10 000 Pa.s at 90°C.

4. Flexible laminate (1) according to any one of the preceding claims, **characterized in that** the at least one polyolefin of the first encapsulation resin (53) has a percentage by mass of oxygen and nitrogen of less than 5% in its main chain or in its linear chain.

5. Flexible laminate (1) according to any one of the preceding claims, **characterized in that** the first encapsulation resin (53) has a resistivity per unit volume of at least 10₁₅Ω.cm.

6. Flexible laminate (1) according to any one of the preceding claims, **characterized in that** the first encapsulation resin (53) has a transmittance greater than or equal to 80%, preferably greater than 90%, for wavelengths of between 315 nm and 1200 nm.

7. Flexible laminate (1) according to any one of the preceding claims, **characterized in that** the second encapsulation resin (73) is selected from among ethylenevinyl acetate (EVA) resins, epoxy resins and polyolefin resins.

8. Method(100) for manufacturing a flexible laminate (1) according to any one of the preceding claims, **characterized in that** it comprises the following steps:
- pre-impregnating (E0), in which the glass-fibre fabric (51) of the front encapsulation layer (5) is impregnated with a first encapsulation resin (53) and the glass-fibre fabric (71) of the back encapsulation layer (7) is impregnated with a second encapsulation resin (73),
- preparing (E1) a stack of layers comprising at least:
∘ a front encapsulation layer (5) comprising at least one glass-fibre fabric (51) and at least a first encapsulation resin (53) comprising at least one polyolefin,
∘ a layer of photovoltaic cells (3), and
∘ a back encapsulation layer (7) comprising a second encapsulation resin (73) and a glass-fibre fabric (71),
- inserting (E2) the stack of layers into a lamination chamber of a lamination furnace,
- evacuating (E3), in order to draw out air that is inside the lamination chamber and between the various layers of the stack,
- compressing (E4) the stack of layers,
- heating (E5) the lamination chamber to a predetermined temperature in order to trigger a polymerization reaction of the first encapsulation resin (53) and the second encapsulation resin (73),
- ventilating (E6) the lamination chamber, and
- removing (E7) the laminate (1) from the lamination chamber.
